# EUROPEAN PATENT APPLICATION

(11) **EP 3 654 455 A1**
(43) Date of publication of application: **20.05.2020**
(21) Application number: 19208120.6
(22) Date of filing: 08.11.2019
(51) Int. Cl.: H01R 12/72, H01R 13/44, H05K 5/00, H01R 13/74, H01R 13/447

(54) **ELECTRICAL APPARATUS**

(30) Priority: 13.11.2018 JP 2018212935
(71) Applicant: Tyco Electronics Japan G.K., Takatsu-ku Kawasaki Kanagawa 213-8535 (JP)
(72) Inventor: Iwai, Daijiro, Kawasaki-shi, Kanagawa 213-8535 (JP)
(74) Representative: Johnstone, Douglas Ian

(57) **Abstract**

Electrical apparatus including an electrical connector (10) having a plurality of terminals (30) for connection to terminals of a mating connector and a connector housing (11) retaining the plurality of terminals (30). The apparatus also includes a case (50) covering at least a portion of the electrical connector (10) and having an opening (51C) through which the mating connector passes, and a circuit board (60) having an electrical circuit connected electrically with the plurality of terminals (30). The connector housing (11) includes a first entrapping structure (21) provided so as to correspond to a gap (CI) between the connector housing (11) and the case (50). The first entrapping structure (21) has a first dead end (26) open towards the gap (CI). If a gap (CI) exists between a connector housing (11) and the case (50), a wire intruding via the gap (CI) can be prevented from reaching a circuit board (60) by the entrapping structure (21).

## Description

### Technical Field

The present invention relates to an electrical connector mounted on a circuit board, and relates to an electrical apparatus having an electrical connector and a case for holding the electrical connector that have been assembled together.

### Background Art

In IEC (International Electrotechnical Commission) standards, protection against the ingress of water, body parts, and solid objects into electrical apparatuses (Ingress Protection) is defined. As an example, "a wire having a diameter of 1 mm is not accessible to a hazardous part" is defined. This definition is also applicable to electrical connectors.

Between a connector housing of an electrical connector and a case containing the electrical connector, a gap occurs inevitably (for example, Figures 5 and 6 of JPH03-163768A). This is due to dimensional tolerance of the connector housing of the electrical connector and the case. Accordingly, between the connector housing and the case, a gap occurs through which the wire may intrude. In an electrical connector mounted on a circuit board to which high voltage is applied, the layout of the circuit board is so determined as to prevent the wire from reaching the range of a hazardous part to which high voltage is applied. That is, the layout is adopted that only allows the wire intruding from the gap to reach a part other than the hazardous part.

### Summary of Invention

### Technical Problem

In view of these circumstances, an object of the present invention is to provide an electrical apparatus capable of preventing a wire intruding through a gap, if any, between the connector housing and the case and preventing such a wire from reaching the circuit board.

### Solution to Problems

An electrical apparatus of the present invention is provided with an electrical connector having a plurality of terminals and a connector housing retaining a plurality of the terminals, a case containing the electrical connector, and a circuit board connected electrically with a plurality of the terminals. Further, the electrical apparatus of the present invention is provided with an entrapping structure provided so as to correspond to at least a portion of a gap between the connector housing and the case. The entrapping structure is characterized by having a dead end with an opening facing the gap.

In the present invention, when the connector housing is provided with a first upper wall and a first lower wall each positioned parallel to the circuit board and at a predetermined distance, and a pair of side walls connecting the first upper wall and the first lower wall, it is preferred that the entrapping structure is provided so as to correspond to the gap between the first side wall and the case.

In the present invention, when a dimension of the opening of the dead end is denoted as L1, and a dimension of the gap between the connector housing and the case is denoted as C1, preferably L1 > C1.

The dead end is preferably formed by being provided with a second lower wall protruding outward in a width direction of the connector housing from the first side wall, a second side wall extending from an outer end of the second lower wall, where said outer end is in the width direction of the second lower wall, and a rear wall connecting rear ends of the second lower wall and the second side wall.

### Advantageous Effects of Invention

According to an electrical apparatus of the present invention, the electrical connector has the entrapping structure, thereby preventing any intruding wire from reaching the circuit board. Therefore, according to the electrical apparatus of the present invention, even when the electrical apparatus is provided with a circuit board to which high voltage is applied, it is unnecessary to adopt a layout taking into consideration where a hazardous part, to which high voltage is applied, should be placed. For this reason, according to the electrical apparatus of the present invention, the degree of freedom of the layout of the circuit board can be increased. Such freedom including the mounting position of the electrical connector, and the number of electrical connectors mounted.

### Brief Description of Drawings

Figure 1 is a front perspective view of an electrical connector according to an embodiment of the present invention;
Figures 2A, 2B, 2C, and 2D illustrate the electrical connector of Figure 1, being a top view, a front view, a bottom view, and a side view, respectively;
Figure 3A is a front perspective view of an electrical apparatus according to an embodiment of the present invention and Figure 3B is an exploded perspective view thereof;
Figures 4A, 4B, and 4C illustrate the electrical apparatus of Figure 3, being a cross-sectional view taken along line A-A of Figure 4B, a front view, and a cross-sectional view taken along line C-C of Figure 4B, respectively; and
Figure 5A is a partial enlarged view of Figure 4A, Figure 5B illustrates a wire intruding parallel to a longitudinal direction from a gap between the electrical connector and a case, and 5C and 5D illustrate a wire intruding at an angle into the gap between the electrical connector and the case.

### Description of Embodiments

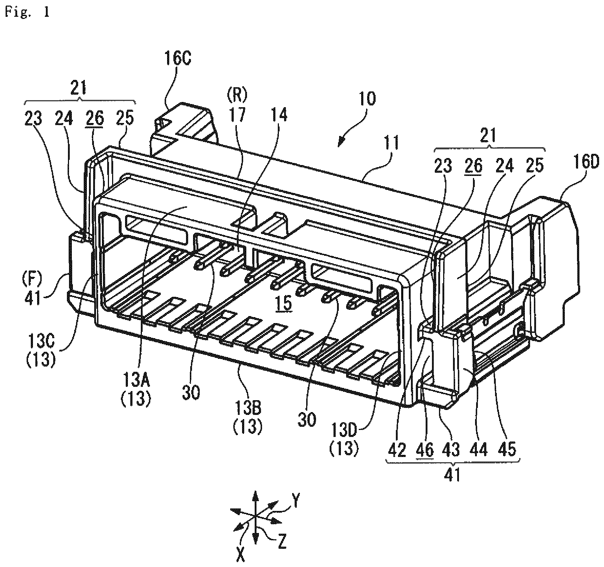

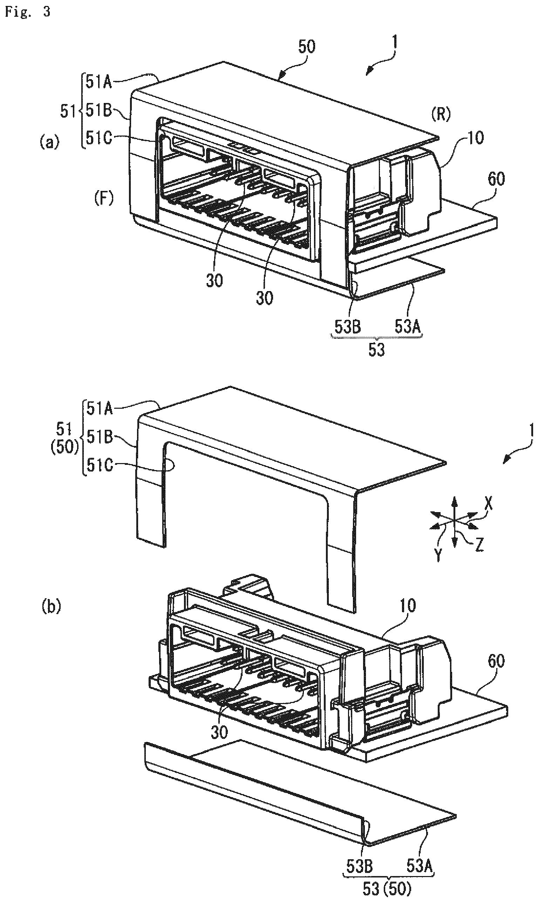

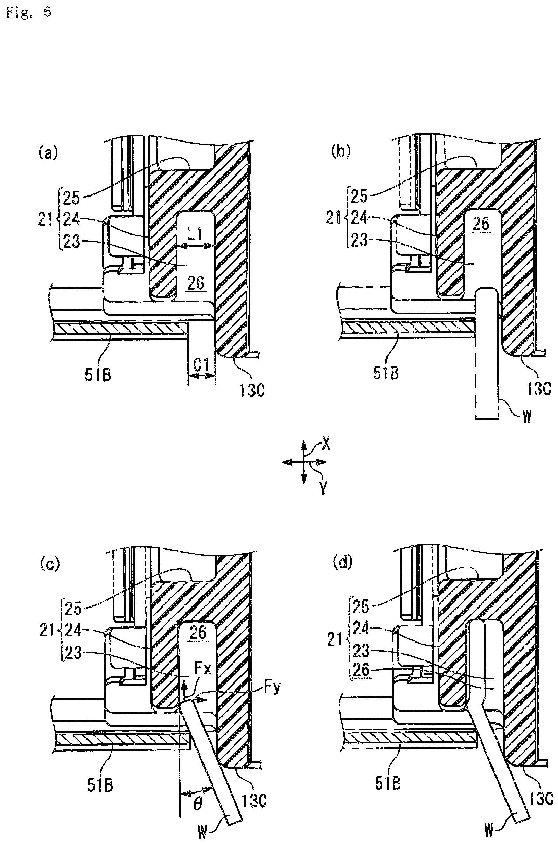

Hereinbelow, with reference to the accompanying drawings, an electrical apparatus 1 according to an embodiment of the present invention will be described. The electrical apparatus 1 is provided with an electrical connector 10, and a case 50 containing the electrical connector 10, and a circuit board 60 mounted with the electrical connector 10, as shown in Figure 3. The electrical apparatus 1 has the electrical connector 10 provided with a first dead end 26 (shown in Figure 5) for guiding an intruding wire W, thereby preventing the wire W from reaching the circuit board 60. It should be noted that, in the electrical apparatus 1, the side of the electrical connector 10 on which the circuit board 60 is disposed is defined as the lower side, and the opposite side is defined as the upper side. In addition, in the electrical apparatus 1, a side on which the electrical connector 10 and a mating connector (not shown) are mated is defined as the front (F), and a side on which a terminal 30 is drawn or pulled is defined as the rear (R). Front (F) and rear (R) may be used as a relative positional relation. In addition, the x-axis direction, the y-axis direction, and the z-axis direction, shown in Figure 1, are defined as the longitudinal direction X, the width direction Y, and the height direction Z, respectively. These definitions are intended to be also applied to the present invention. Hereinbelow, the configuration of each element of the electrical apparatus 1 will be described one by one, and thereafter a function and an effect achieved by the electrical apparatus 1 will be described.

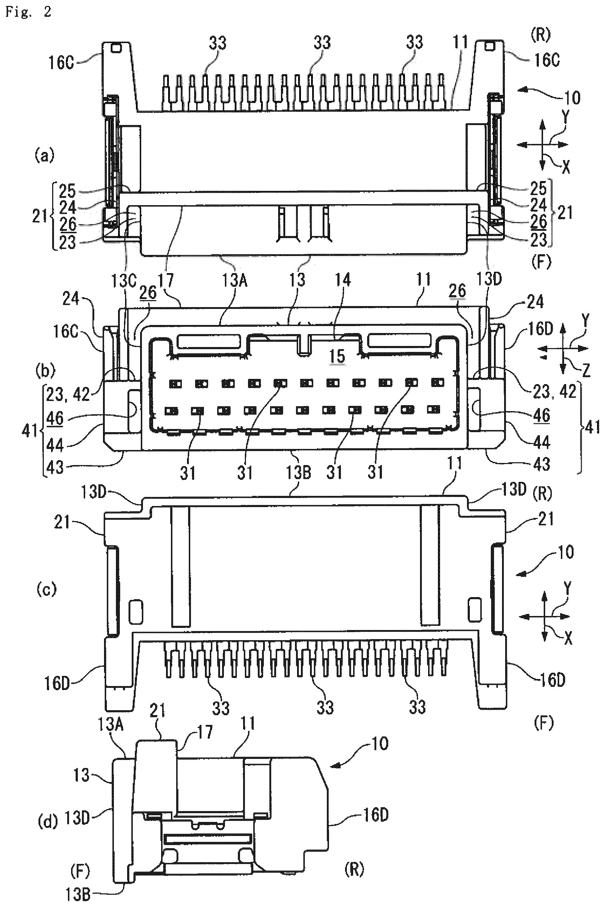

The electrical connector 10 is provided with a connector housing 11 mated with a connector housing of the mating connector (not shown), and a plurality of terminals 30 retained in the connector housing 11, as shown in Figure 1. The connector housing 11 is provided with, at its front side, a mating sleeve 13 into which the mating connector (not shown) is mated, as shown in Figure 1 and Figures 2A and 2B. The mating sleeve 13 has a receiving space 15 formed therein, and the mating connector is inserted into the receiving space 15, and thereby mated with the connector housing 11. The connector housing 11 is integrally formed by injection forming of resin.

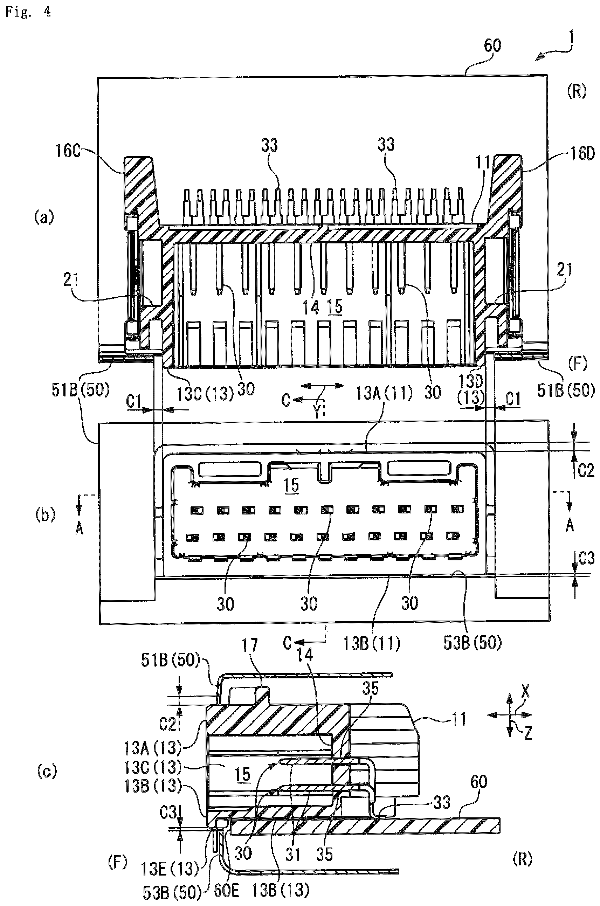

The mating sleeve 13 is provided with an upper wall (first upper wall) 13A, a lower wall (first lower wall) 13B positioned at a predetermined distance from the upper wall 13A, a front side wall (first side wall) 13C connecting one ends in the width direction Y of the upper wall 13A and the lower wall 13B, and a front side wall (first side wall) 13D connecting the other ends in the width direction Y of the upper wall 13A and the lower wall 13B, as shown in Figures 1 and Figures 2A, 2B, and 2D. A terminal retaining wall 14 (shown in Figure 4A) is provided at the rear end (R) of the mating sleeve 13, and a space enclosed with the upper wall 13A, the lower wall 13B, the front side wall 13C, the front side wall 13D and the terminal retaining wall 14 constitutes the receiving space 15.

Behind (R) the terminal retaining wall 14, a rear side wall 16C and a rear side wall 16D are provided at a predetermined distance from each other in the width direction Y. The distance between the rear side wall 16C and the rear side wall 16D is set to be wider than the distance between the front side wall 13C and the front side wall 13D, and a board connecting portion 33 of the terminal 30 is led or extends out of the connector housing in a region between the rear side wall 16C and the rear side wall 16D.

The mating sleeve 13 is provided with a flange 17 at its front (F). The flange 17 is so provided as to extend from near the center in the height direction Z of the front side wall 13C toward near the center in the height direction Z of the front side wall 13D through the upper wall 13A. The flange 17 at the upper wall 13A has a plate-like shape protruding upward in the height direction Z. The flange 17 at the front side wall 13C and the front side wall 13D protrudes by a predetermined amount in the width direction Y and protrudes frontward (F) from its distal end, and the shape as viewed from above is a C-like in form. The flange 17 is provided for the purpose of preventing a wire W intruding from a gap between the upper wall 13A of the mating sleeve 13 and the case 50 from reaching the circuit board 60. The details of this point will be mentioned in the description of the function/effect of the invention described later.

In addition, the mating sleeve 13 has a first entrapping structure 21 provided on each of outer peripheral faces of the front side wall 13C and the front side wall 13D. The first entrapping structure 21 is provided for the purpose of entrapping by a wire W that could intrude from the gap between the mating sleeve 13 and the case 50, thereby preventing the wire W from reaching the circuit board 60.

The first entrapping structure 21 is provided with a lower wall (second lower wall) 23 protruding outward in the width direction from each of the front side wall 13C and the front side wall 13D, a side wall (second side wall) 24 extending from an outer end in the width direction Y of the lower wall 23, and a rear wall 25 connecting rear ends of the lower wall 23 and the side wall 24, as shown in Figures 1 and Figure 2B. The side wall 24 and the rear wall 25 are provided as portions of the flange 17 described above.

A space enclosed with the lower wall 23, the side wall 24, the rear wall 25 and the front side wall 13C or the front side wall 13D forms the first dead end 26. A front end of the front side wall 13C or the front side wall 13D protrudes forward (F) more than front ends of the lower wall 23, the side wall 24 and the rear wall 25. The first dead end 26 has an opening provided so as to correspond to a gap C1 described later. The dimension L1 in the width direction Y of the first dead end 26 is larger than the gap C1 (see Figure 5).

In addition, the mating sleeve 13 is provided with a second entrapping structure 41 below the first entrapping structure 21. The second entrapping structure 41 is also provided for the same purpose as the first entrapping structure 21. The second entrapping structure 41 is provided with basically the same structure as the first entrapping structure 21, and provided with an upper wall 42 protruding outward in the width direction from each of the front side wall 13C and the front side wall 13D, and a lower wall 43 provided at a predetermined distance in the height direction Z from the upper wall 42, as shown in Figure 1. The second entrapping structure 41 is provided with a side wall 44 connecting outer ends in the width direction Y of the upper wall 42 and the lower wall 43, and a rear wall 45 connecting rear ends of the upper wall 42, the lower wall 43 and the side wall 44. A space enclosed with the upper wall 42, the lower wall 43, the side wall 44, the rear wall 45 and the front side wall 13C or the front side wall 13D forms a second dead end 46.

The terminal 30 is provided with a mating connecting portion 31 serving for connection with a terminal of the mating connector, and the board connecting portion 33 serving for electrical connection with the circuit board 60, as shown in Figure 4C. The terminal 30 connects the mating connecting portion 31 and the board connecting portion 33, and is provided with a retained portion 35 press-fitted in the terminal retaining wall 14 of the connector housing 11. In the terminal 30, the mating connecting portion 31 and the retained portion 35 extend substantially parallel to a direction of mating with the mating connector (longitudinal direction X) and, in addition, the board connecting portion 33 extends downwardly toward the circuit board 60. The terminal 30 is formed by stamping a highly-conductive metal sheet made of, for example, a copper alloy, and simultaneously bending it at predetermined positions. A plurality of terminals 30 are press-fitted into the terminal retaining wall 14, and thereby retaining it in the connector housing 11. In this state, the board connecting portion 33 is joined by soldering to a required part of the circuit board 60.

The case 50 made of metal is composed of an upper case 51 and a lower case 53 containing the electrical connector 10 and the circuit board 60 mounted with the electrical connector 10, as shown in Figures 3A and 3B. It should be noted that only a part of the case 50 that covers the connector 10 is shown, and the other parts of the case 50 are not shown. The upper case 51 is provided with an upper wall 51A covering the electrical connector 10 from the top, and a front wall 51B covering the electrical connector 10 from the front (F). In the front wall 51B, an opening 51C is provided that is necessary for allowing passage of the mating connector that is to be mated with the electrical connector 10. The lower case 53 is provided with a lower wall 53A covering the electrical connector 10 from the bottom, and a front wall 53B covering the electrical connector 10 from the front (F). The front wall 53B is located outside the lower wall 13B of the connector housing 11 so as not to interfere with the mating of the mating connector, with the electrical connector 10.

The case 50 has the upper case 51 and the lower case 53 assembled together such that they have a predetermined positional relation with the electrical connector 10, as shown in Figure 3A. In this regard, because of a dimensional tolerance between the connector housing 11 of the electrical connector 10 and the case 50, it is very difficult to eliminate a gap between the connector housing 11 and the case 50.

The gap that occurs when the connector housing 11 and the case 50 are assembled together will be described with reference to Figures 4A, 4B and 4C. Figures 4A and 4B and Figure 5A illustrate a gap between the connector housing 11 and the case 50 in the width direction Y. That is, the gap C1 occurs between the front side wall 13C of the connector housing 11 and the case 50. This would also be the case between the front side wall 13D and the front wall 51B. Figures 4B and 4C illustrate gaps C2, C3 in the height direction Z. The gap C2 occurs between the upper wall 13A of the connector housing 11 and the front wall 51B of the case 50. In addition, the gap C3 occurs between the lower wall 13B of the connector housing 11 and the front wall 53B of the case 50.

All the gaps C1 to C3 can be an entrance allowing for the intrusion of the wire W. It is necessary to prevent the wires W intruding from these entrances from reaching a hazardous region of the circuit board 60. Of the gaps C1 to C3, the wires W intruding via the gaps C2 and C3 cannot reach the circuit board 60 for the reasons detailed below.

Let us assume that the wire W intrudes from the gap C2 between the upper wall 13A and the front wall 51B. See Figure 4C. The wire W hits against the flange 17 of the connector housing 11, and thus the wire W is unlikely to intrude further. Even if the wire W intrudes over the flange 17, because of the presence of the connector housing 11 between the wire W and the circuit board 60, the connector housing becomes an obstacle so that the wire W cannot reach the circuit board 60.

Let us assume that the wire W intrudes via the gap C3 between the lower wall 13B and the front wall 53B. See Figure 4C. A front end of the lower wall 13B in the connector housing 11 has a ridge 13E protruding downward, and accordingly, the wire W intrudes upward. Therefore, even if the wire W intrudes over the ridge 13E, the wire W hits against the lower wall 13B. Even if the wire W intrudes further rearwards (R), the wire W hits against a front edge 60E of the circuit board 60. The electrical connector 10 is mounted on the circuit board 60 behind (R) the front edge 60E and thus there is no space for the wire W to come in between the circuit board 60 and the electrical connector 10.

Unlike the gaps C2 and C3, the gap C1 can be an entrance for intrusion of a wire W and the wire W intruding therethrough may reach the circuit board 60. For this reason, the electrical connector 10 of the present embodiment is provided with the entrapping structure 21 for preventing the wire W from reaching the circuit board 60. Hereinbelow, the function and effect achieved by the first entrapping structure 21 will be described with reference to Figure 5. Though the description is omitted, the second entrapping structure 41 achieves the same effect.

As shown in Figure 5B, if the wire W intrudes parallel to the longitudinal direction X into the gap C1 and continues intruding, the wire W advances through the first dead end 26 and hits against the rear wall 25. Next, as shown in Figure 5C, if the wire W intrudes at an angle to the longitudinal direction X into the gap C1, the tip of the wire W hits against the inside of a distal end of the side wall 24. An angle of inclination θ is an acute angle to the longitudinal direction X, and thus a load applied to a tip portion of the wire W has a component Fx in the longitudinal direction X larger than a component Fy in the width direction Y. Therefore, if the wire W continues to be pushed in, the wire W advances through the first dead end 26. Though omitted in the figures, if the wire W intrudes into the gap C1 at a reverse angle from what is shown in Figure 5C, the wire W comes into contact with an outer face of the front side wall 13C, advances deep into the first dead end 26 while being guided by the outer face of the front side wall 13C, and hits the rear wall 25.

As described above, regarding the gap C1, since the electrical connector 10 has the entrapping structure 21, even if a wire W intrudes, the wire W can be prevented from reaching the circuit board 60. Therefore, according to the electrical apparatus 1 of the present embodiment, even when the electrical apparatus 1 is provided with the circuit board 60 to which high voltage is applied, it is unnecessary to put a limitation on a region where a hazardous part to which high voltage is applied is positioned, or the limitation, if any, can be narrowed. Therefore, according to the electrical apparatus 1 of the present embodiment, the degree of freedom of a layout can be increased, including a position in which the electrical connector 10 is mounted, and the number of electrical connectors 10 mounted, in addition to the region where the hazardous part is positioned.

The dimension L1 in the width direction Y of the first dead end 26 according to the present embodiment is larger than the gap C1 (see Figure 5A). Therefore, as shown in Figure 5B, if the wire W intrudes parallel to the longitudinal direction X, the wire W is inevitably entrapped into the first dead end 26. In addition, as shown in Figures 5C and 5D, even if the wire W intrudes at an angle to the longitudinal direction X, the wire W hits against the inside of the distal end of the side wall 24 at the acute angle θ, and thus the wire W is entrapped in the first dead end 26 without difficulty.

In addition, the first dead end 26 according to the present embodiment is formed by being provided with the front side wall 13C or the front side wall 13D that is an outer wall of the connector housing 11, the lower wall 23, the side wall 24, and the rear wall 25. That is, the first dead end 26, excluding the opening, is closed to the outside in the longitudinal direction X, the width direction Y and the height direction Z. This enables the first dead end 26 not only to prevent the wire W intruding from reaching the circuit board 60, but also to prevent the wire W intruding from reaching a region other than the circuit board 60 to cause trouble.

Though a preferred embodiment of the present invention has been described above, other than the above, without departing from the scope of the present invention, a configuration or feature included in the above embodiment may be selectively removed, or may be replaced suitably with another configuration or feature.

The connector housing 11 according to the present embodiment is provided with the upper wall 13A and the lower wall 13B each positioned parallel to the circuit board 60 and at a predetermined distance from each other, and the pair of side walls 13C, 13D connecting the upper wall 13A and the lower wall 13B. As described above, regarding the gaps C2 and C3, it is not possible that the wire W reaches the circuit board 60. For this reason, the entrapping structure 21 in the present embodiment is provided only for the gap C1 between the front side walls 13C, 13D and the case 50 through which a wire W may intrude. On the other hand, the entrapping structure 21 is not provided for parts corresponding to the gaps C2 and C3 for the reasons described above, but this is not an element that limits the present invention. That is, an entrapping structure of the present invention may be provided for any gap between the connector housing 11 and the case 50 through which a wire W may intrude.

In addition, the entrapping structure in the present invention is not limited to the forms of the first entrapping structure 21 and the second entrapping structure 41 shown in the embodiment. That is, the first entrapping structure 21 and the second entrapping structure 41 may have any form as long as they have the first dead end 26 and the second dead end 46, respectively, for entrapping a wire intruding via a gap. For example, the side walls 23, 44 shown above have a rectangular vertical section, but a face opposite the connector housing 11 may be an inclined face tapering forwardly. In addition, the second entrapping structure 41 according to the present embodiment is provided with the upper wall 42. However, considering only preventing the wire W from reaching the circuit board 60, the second entrapping structure 41 does not necessarily have to be provided with the upper wall 42. That is, it would suffice if a dead end of the present invention is provided for a path through which a wire can reach the circuit board, as in the first entrapping structure 21.

### Reference signs list:

- 1: electrical apparatus
- 10: electrical connector
- 11: connector housing
- 13: mating sleeve
- 13A: upper wall (first upper wall)
- 13B: lower wall (first lower wall)
- 13C: front side wall (first side wall)
- 13D: front side wall (first side wall)
- 14: terminal retaining wall
- 15: receiving space
- 16C: rear side wall
- 16D: rear side wall
- 17: flange
- 21: first entrapping structure
- 23: lower wall (second lower wall)
- 24: side wall (second side wall)
- 25: rear wall
- 26: first dead end
- 30: terminal
- 31: mating connecting portion
- 33: board connecting portion
- 35: retained portion
- 41: second entrapping structure
- 42: upper wall
- 43: lower wall
- 44: side wall
- 45: rear wall
- 46: second dead end
- 50: case
- 51: upper case
- 51A: upper wall
- 51B: front wall
- 51C: opening
- 53: lower case
- 53A: lower wall
- 53B: front wall
- 60: circuit board
- C1, C2, C3: gap
- W: wire
- X: longitudinal direction
- Y: width direction
- Z: height direction

## Claims

1. An electrical apparatus comprising:
an electrical connector (10) having a plurality of terminals (30) and a connector housing (11) retaining a plurality of the terminals (30);
a case (50) containing the electrical connector (10);
a circuit board (60) connected electrically with a plurality of the terminals (30); and
an entrapping structure (21, 41) so provided as to correspond to at least a portion of a gap (C1, C2, C3) between the connector housing (11) and the case (50), wherein
the entrapping structure (21, 41) has a dead end (26, 46) having an opening facing the gap (C1, C2, C3).

2. The electrical apparatus according to claim 1, wherein
the connector housing (11) comprises
a first upper wall (13A) and a first lower wall (13B) each positioned parallel to the circuit board and at a predetermined distance apart, and
a pair of first side walls (13C, 13D) connecting the first upper wall (13A) and the first lower wall (13B), and
the entrapping structure (21, 41) is provided so as to correspond to the gap (C1) between the first side wall (13C, 13D) and the case (50).

3. The electrical apparatus according to claim 1 or 2, wherein
when a dimension of the opening of the dead end (26, 46) is denoted as L1, and
a dimension of the gap (C1, C2, C3) between the connector housing (11) and the case (50) is denoted as C1,
L1 > C1.

4. The electrical apparatus according to claim 2 or any claim depending thereon, wherein the dead end (26, 46) is formed by a second lower wall (23) protruding outward in a width direction from the connector housing (11) from the first side wall (13C, 13D), a second side wall (24) rising from an outer end in the width direction of the second lower wall (23), and a rear wall (25) connecting rear ends of the second lower wall (23) and the second side wall (24).
